# EUROPEAN PATENT APPLICATION

(11) **EP 4 664 720 A1**
(43) Date of publication of application: **17.12.2025**
(21) Application number: 25179192.7
(22) Date of filing: 27.05.2025
(51) Int. Cl.: H02J 7/00, G01R 31/389, H02J 7/34, H02J 9/06

(54) **SIGNAL GENERATOR FOR MONITORING AND DIAGNOSTICS OF BATTERIES, AND ELECTRONIC DEVICE COMPRISING SUCH GENERATOR**

(30) Priority: 10.06.2024 IT 202400013210
(71) Applicant: Sabbadin, Giovanni, 31100 Treviso (IT); Sabbadin, Massimo, 31100 Treviso (IT)
(72) Inventor: ARU, Francesco, 31100 Treviso (IT); TONIATO, Andrea, 31100 Treviso (IT)
(74) Representative: Mitola, Marco

(57) **Abstract**

A signal generator (10) configured to be connected to at least one battery string (12) and adapted to induce an alternating electrical signal in said at least one battery string (12), comprises: a driving circuit assembly (20, 40) operatively connectable to an electronic processing unit (160); a power supply branch (30) adapted to draw energy from the battery string (12); an accumulator block (50) adapted to store energy. The driving circuit assembly is configured to generate the alternating electrical signal based on signal parameters determined by the electronic processing unit (160). The accumulator block (50) is adapted to be charged by the power supply branch (30) and to supply the driving circuit assembly with the stored energy. The accumulator block (50) is configured to store energy at a storage rate lower than the consumption rate of the driving circuit assembly.

## Description

### Field of application

The present invention concerns a signal generator for monitoring and diagnostics of batteries, in particular for uninterruptible power supplies, also referred to by the Anglo-Saxon acronym UPS ("Uninterruptible Power Supply"), and an electronic device comprising such generator. In particular, the present invention concerns a signal generator adapted to cause an electrical effect on the batteries of a UPS, which can be used to perform monitoring measurements.

### Prior art

As is known, in the field of electronics for UPS, there are several methods to diagnose the operating state of a battery, and multiple chemical-physical factors influence its degradation.

The parameter most commonly considered to assess the state of a battery, particularly for lead-acid batteries commonly used in UPSs, is the internal resistance.

The value of the internal resistance is nominally declared by the manufacturer but is destined to change over time. Measuring the internal resistance of a battery and comparing it with the nominal value allows one to understand whether the battery is capable of supplying the electrical energy stored in it.

In particular, such value, being very low, requires a particularly accurate measuring method employing high-quality electronic technologies, which are usually very expensive.

Moreover, such electronic technologies must be capable of adapting to the various UPS configurations, which may be composed of multiple batteries connected together, forming strings and/or branches.

At the same time, remote control of the measurements must also be ensured with a certain time frequency.

Consequently, it is necessary to provide automatic control of the circuitry, especially since resistance measurements are performed also several times a day.

These issues have been solved by the known art by providing systems equipped with multiplexers capable of selecting the single battery of the string and systems equipped with cloud and telecom network for remote control.

Such solutions do not provide for making the signal generator adaptable to the various types of UPSs, the signal generator i.e., the circuital element that causes an electrical effect in the batteries without which the measurement would not take place.

Indeed, the problem of generating a signal suitable for all possible types of UPSs, both in terms of configuration and in terms of the number of connected batteries, remains unresolved.

Furthermore, since signal generation constitutes a disturbance on the battery load, it must be homogeneously applied to all the batteries in the string and must be of limited duration in time, in order not to accelerate the deterioration of the batteries themselves and not to result in excessive consumption. The present solutions of the known art do not allow for this type of control over the generator.

Therefore, the attempts of the known art do not fully meet the present needs.

### Summary of the invention

There is therefore a felt need to solve the aforementioned drawbacks and limitations related to the prior art.

A first object of the present invention is to provide a generator capable of generating a signal suitable for the type and configuration of the battery string present in a given uninterruptible power supply.

A further object of the present invention is to provide a generator that makes it possible to limit the deterioration of the circuitry, in particular of the battery block, present in the uninterruptible power supply, while at the same time ensuring a reduction in consumption.

Furthermore , there is a felt need to provide a signal generator capable of being integrated into an electronic device suitable for carrying out the calculation of the internal resistance of the batteries and for sending the data detected to a control unit for remote monitoring.

These needs are at least partially met by a signal generator in accordance with claim 1 and by an electronic device comprising such generator according to claim 12.

### Description of the drawings

Further features and advantages of the present invention will become more clearly apparent from the following description of its preferred and non-limiting embodiments, in which:
- figure 1 schematically represents the block diagram of a signal generator according to one possible embodiment;
- figure 2 schematically represents some details of the block diagram of figure 1 according to one possible embodiment;

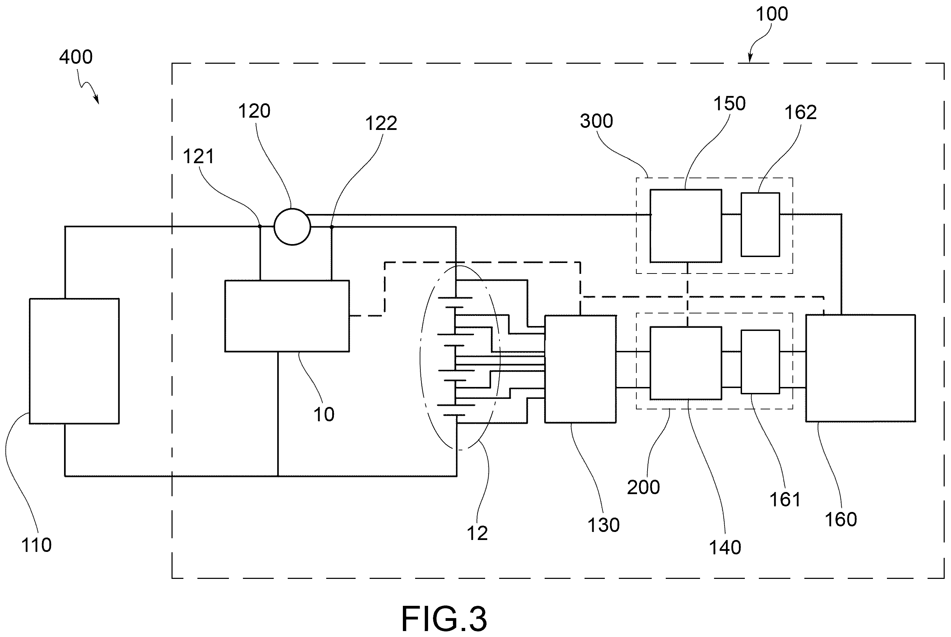

- figure 3 schematically represents the block diagram of an electronic device provided with the signal generator shown in figure 1 according to one possible embodiment;
- figure 4 schematically represents the block diagram of an electronic device provided with the signal generator shown in figure 1 according to an alternative embodiment.
The elements or parts of elements in common among the embodiments described below will be denoted by the same reference numerals.

### Detailed description

In the accompanying figures, the general reference number 10 denotes a signal generator configured so as to be connectable to one or more battery strings 12 and adapted to induce an alternating electrical signal through said battery strings 12.

The signal generator 10 comprises:
- a driving circuit assembly 20, 40 operatively connectable to an electronic processing unit 160. Said driving circuit assembly is configured to generate the alternating signal on the basis of signal parameters determined by the electronic processing unit 160;
- a power supply branch 30 adapted to draw energy from the battery string 12;
- an accumulator block 50 adapted to store energy. Said accumulator block 50 is adapted to be charged by the power supply branch 30 and to supply the driving circuit assembly with the stored energy.

The accumulator block 50 is further configured to store energy at a storage rate lower than the consumption rate of the driving circuit assembly.

This feature enables the generator 10 to automatically shut down after a short operating time, without the need for a dedicated shut-off system.

Moreover, ensuring a short injection time of the signal allows for reducing any deterioration of components, in particular of the batteries, increasing the safety of the system and reducing the consumption associated with the execution of the measurements.

In accordance with one possible embodiment, the signal generator 10 further comprises a travel branch 60, adapted to make the alternating electrical signal generated by the driving circuit assembly 20, 40 flow towards the battery string 12.

The travel branch 60 is therefore configurable so as to adjust the value of the alternating electrical signal generated as a function of the size of the battery string 12. Therefore, it is possible to exclude unnecessary elements in the configuration of the string to which it is connected, as will be further explained later.

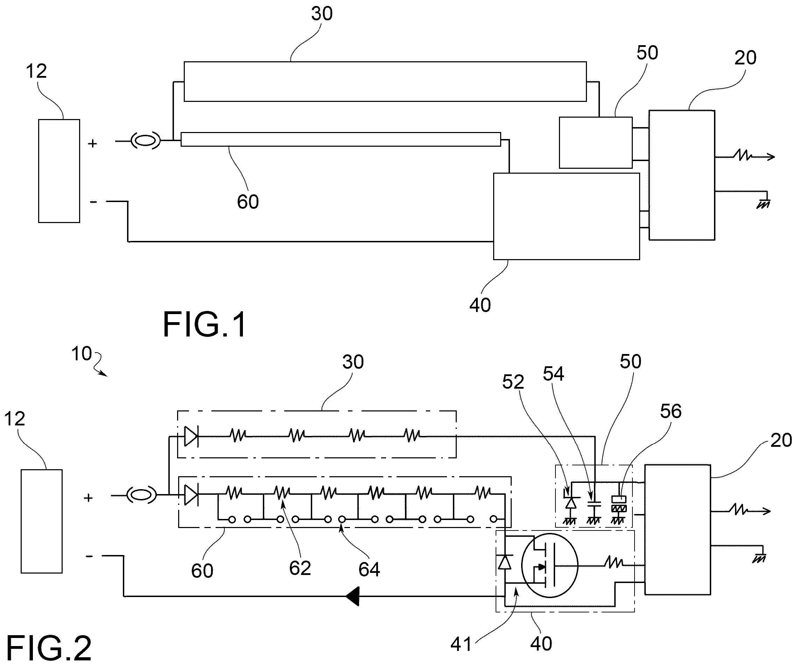

According to one possible embodiment, shown in figure 1, the driving circuit assembly 20, 40 of the signal generator 10 comprises a driver 20 operatively connectable to the electronic processing unit 160 and a signal modulator 40 adapted to be driven by the driver 20 to generate the alternating signal.

The driver 20 is thus controlled by the electronic processing unit 160, which determines its activation as well as the characteristics of the signal generated, in particular the frequency.

In accordance with a further embodiment, the accumulator block 50 introduced above comprises:
- at least one storage capacitor 54, 56 adapted to store energy in the form of storage charge; and
- a Zener diode 52 adapted to limit the storage charge and connected in parallel to the at least one storage capacitor 54, 56, as illustrated in figure 2.

More specifically, the storage capacitor 54, 56 is formed by connecting together in parallel a non-polarised capacitor 54 and a polarised capacitor 56.

In particular, the former is configured to store charge/energy, known as capacitance, and to be used with alternating signals, while the latter is configured to store a charge greater than the charge stored by the non-polarised capacitor 54.

These characteristics are made possible by the geometries and materials of which the capacitors are made, while the amount of charge storable is regulated by the Zener diode, as it is connected in parallel to the two capacitors.

According to another possible embodiment, the accumulator block 50 of the signal generator 10 is charged by the power supply branch 30 and is discharged by the driving circuit assembly 20, 40 when the electronic processing unit 160 enables the driver 20.

Specificall y, the driver 20 has a consumption rate Vc of the charge stored in the accumulator block 50 greater than the accumulation rate Vs of the same charge in the accumulator block 50, so as to allow the driver 20 to automatically deactivate and interrupt the signal generation.

As mentioned earlier, this automatic shut-off has a dual effect: to limit the deterioration of the batteries of the string and to reduce the consumption related to the measurements.

A further embodiment also provides that the travel branch 60 comprises:
- at least one resistance 62; and
- at least one bypass switch 64 connected to each other in parallel.

In other words, the travel branch 60 consists of a predefined number of resistances 62, and each resistance is associated with a bypass switch 64.

The bypass switches are controllable to switch between a closed conduction configuration and an open interdiction configuration as a function of the number of batteries present in the battery string 12, in order to increase or decrease the electrical resistance of the travel branch 60.

More specifically, as the number of batteries in the string decreases, the current passing through such batteries must be of lower intensity. To decrease the current, it is necessary to increase the total resistance of the travel branch 60 by increasing the number of open bypass switches 64.

Conversely, as the number of batteries in the string increases, the current intensity passing through the batteries must be higher. To increase the current, it is necessary to decrease the total resistance of the travel branch 60 by increasing the number of closed bypass switches 64.

According to an additional embodiment, the signal modulator 40 comprises at least one electronic switch 41. This switch 41 is controllable to switch between an open configuration and a closed configuration in order to generate a periodic signal.

The switch 41 can be implemented with known electronic elements or devices, such as for example a MOSFET.

In summary, the signal generator 10 operates as follows: the power supply branch 30 draws energy from the battery string 12 and recharges the accumulator block 50. Depending on the size of the string, the charging time may vary but remains always shorter than the discharge time.

The energy accumulator block 50 powers the driver 20. This is charged by the power supply branch 30 and discharges when the driver 50 is active, that is, when the electronic processing unit 160 enables the driver. Once the accumulator block 50 is discharged, the driver 20 automatically deactivates, interrupting signal generation.

The driver 20 drives a signal modulator 40. This is controlled by the electronic processing unit 160, which determines the activation and characteristics of the signal generated.

The travel branch 60 is a branch in which the generated signal flows. Based on the size of the battery string, the branch can be modified to increase or decrease the electrical resistance of the branch itself. In this way, the value of the current generated remains within a defined interval.

The signal modulator 40 is a circuit that makes electric current flow in the travel branch 60 based on the driving provided by the driver 20.

The signal generator 10 just described is suitable for integration into an electronic device 100 whose purpose is to carry out the resistance measurement of the batteries in the string.

Indeed, such electronic device 100 comprises:
- a signal generator 10 having the characteristics described above;
- a primary measuring block 300 adapted to measure an alternating electrical signal magnitude M1 representative of the alternating electrical signal generated by the generator;
- at least one secondary measuring block 200 adapted to measure a battery magnitude M2 representative of a battery electrical signal of at least one battery in the string crossed by the alternating electrical signal.

The alternating electrical signal magnitude M1 and the battery magnitude M2 are comparable with each other as they are magnitudes of the same type, as will be specified later.

The electronic device 100 further comprises at least one electronic processing unit 160 operatively connected to the generator.

In particular, the electronic processing unit 160 is capable of:
- determining the parameters of the alternating electrical signal and supplying said parameters to the driving circuit assembly;
- receiving from the primary measuring block 300 and from the secondary measuring block 200 the alternating electrical signal magnitude M1 and the battery magnitude M2.

In addition, the electronic processing unit 160 may be provided with, or connected to, a resistance meter adapted to determine the internal resistance value of at least one battery present in the string by comparing the alternating electrical signal magnitude M1 and the battery magnitude M2.

The secondary measuring block 200, in order to measure the battery magnitude M2, must be connected to the ends of the battery concerned; consequently, necessarily, each battery whose state is to be diagnosed will be associated with a secondary measuring block 200.

In an alternative embodiment, it is possible to provide a multiplexer 130 to be connected to the ends of the entire battery string, which selects the battery concerned. The multiplexer 130 is also then connected to the secondary measuring block 200 for the execution of the measurement.

This solution is not only more advantageous from an economic point of view but also allows for a reduction in the number of secondary meters to be used.

More specifically, the primary measuring block 300 comprises a primary signal-conditioning path 150 and a primary analogue-to-digital converter ADC 162; while the secondary measuring block 200 comprises a secondary signal-conditioning path 140 and a secondary analogue-to-digital converter ADC 161.

According to a further embodiment, the primary measuring block 300 comprises only a primary signal-conditioning path 150 and the secondary measuring block 200 comprises only a secondary signal-conditioning path 140.

The primary and secondary analogue-to-digital converters ADC 162, 161, on the other hand, are integrated into a microprocessor containing the electronic processing unit 160.

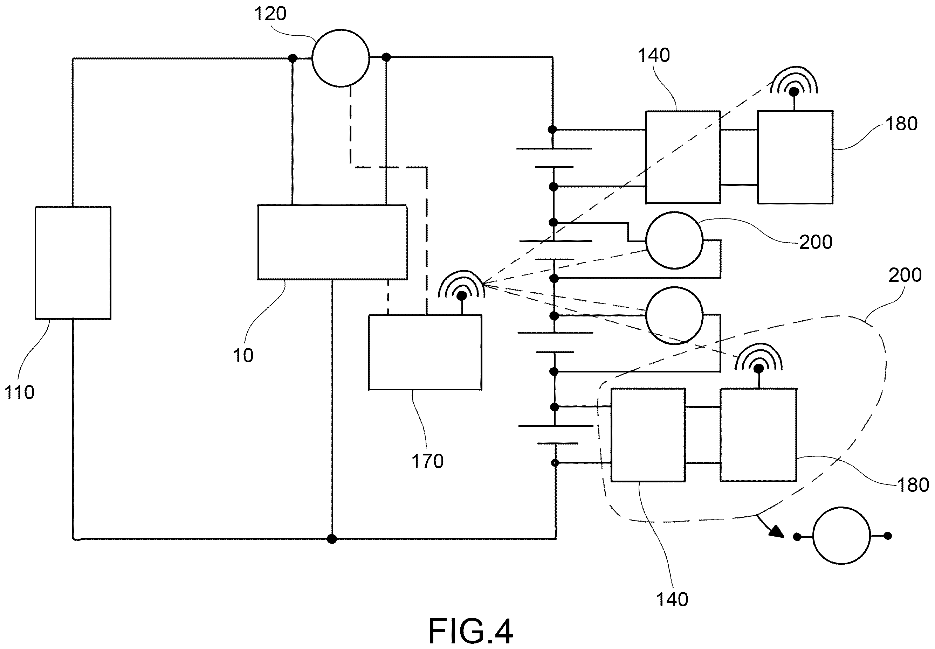

A further embodiment (illustrated for example in figure 4) provides for the use of multiple electronic processing units, capable of communicating wirelessly with each other.

Specifically, there are at least two electronic processing units 170, 180, wherein:
- a first electronic processing unit 170, configured to receive from the primary measuring block 300 the alternating electrical signal magnitude M1;
- at least a second electronic processing unit 180, configured to receive from the secondary measuring block 200 the battery electrical signal magnitude M2.

Potentially, it is possible to have as many second electronic processing units 180 as batteries in the string.

More specifically, one of said first electronic processing unit 170 and at least one second electronic processing unit 180 is configured to send to the other the respective electrical signal magnitude.

One of the first electronic processing unit 170 and the at least one second electronic processing unit 180 may be provided with, or connected to, a resistance meter adapted to determine the internal resistance value by comparing the signal magnitude M1 and the battery magnitude M2, as already described above.

Alternatively, the first electronic processing unit 170 and the at least one second electronic processing unit 180 may be configured to send their respective electrical signal magnitude to the resistance meter.

In other words, there are three modes of communication between the electronic processing units: the first provides that unit 170 sends the signal magnitude M1 to the at least one unit 180, which already contains the battery magnitude M2, and then sends both magnitudes to the meter; the second provides that the at least one unit 180 sends the battery magnitude M2 to unit 170, which already contains the signal magnitude M1, and then sends both magnitudes to the meter; and the third provides that both unit 170 and the at least one unit 180 send their respective magnitudes to the meter.

In one embodiment, the alternating electrical signal is a current signal. In this case, the electronic device 100 may be provided with an alternating current transducer 120, connected to the signal generator 10 and adapted to proportionally convert the alternating current signal into an alternating voltage signal. Therefore, the alternating electrical signal magnitude M1 is the time-based module of the alternating voltage signal and the battery magnitude M2 is the time-based module of the battery electrical voltage.

Finally, the electronic device 100 also has the task of evaluating the state of the components within the uninterruptible power supply, regardless of the state of the batteries.

In a new embodiment, it is thus possible to define an electricity storage unit 400 consisting of at least one uninterruptible power supply 110 and an electronic device 100, as defined above. The electronic device 100 is then connectable to the battery string 12 of the uninterruptible power supply 110.

A feature of the signal generator 10, in this case, is that it is provided with a double coupling so as to inject the alternating signal respectively upstream 121 or downstream 122 of the transducer 120.

The signal injected upstream 121 enables the transducer 120 to proportionally convert the alternating current signal flowing in the battery string 12 into an alternating voltage signal. In this case, the downstream injection 122 is deactivated.

Conversely, the signal injected downstream 122 enables the transducer 120 to proportionally convert the alternating current signal flowing in the interface circuitry of the uninterruptible power supply 110 into an alternating voltage signal. On the contrary, in this case, the upstream injection 121 is deactivated.

To the embodiments described above, the skilled person may, in order to meet specific needs, make modifications and/or replace described elements with equivalent elements, without thereby departing from the scope of the appended claims.

## Claims

1. Signal generator (10) configured to be connected to at least one battery string (12) and adapted to induce an alternating electrical signal in said at least one battery string (12), comprising:
- a driving circuit assembly (20, 40) operatively connectable to an electronic processing unit (160), the driving circuit assembly being configured to generate the alternating electrical signal based on signal parameters determined by the electronic processing unit (160);
- .a power supply branch (30) adapted to draw energy from the battery string (12);
- .an accumulator block (50) adapted to store energy, the accumulator block (50) being adapted to be charged by the power supply branch (30) and to power the driving circuit assembly with the stored energy, the accumulator block (50) being configured to store energy at a lower storage rate compared to the consumption rate of the driving circuit assembly.

2. Signal generator according to claim 1, further comprising a travel branch (60) adapted to allow the alternating signal generated by the driving circuit assembly (20, 40) to flow towards the battery string (12), said travel branch being configurable so as to adjust the value of the alternating electrical signal generated as a function of the size of the battery string (12).

3. Signal generator according to claim 1 or 2, wherein said driving circuit assembly (20, 40) comprises a driver (20) operatively connected to the electronic processing unit (160) and a signal modulator (40) adapted to be driven by the driver (20) to generate the alternating signal.

4. Signal generator (10) according to any one of the preceding claims, wherein said accumulator block (50) comprises:
- .at least one storage capacitor (54, 56) adapted to store energy in the form of storage charge; and
- .a Zener diode (52) adapted to limit the storage charge and connected in parallel to the at least one storage capacitor (54, 56).

5. Signal generator (10) according to the preceding claim, wherein said at least one storage capacitor (54, 56) comprises a non-polarised capacitor (54) and a polarised capacitor (56), connected in parallel with each other.

6. Signal generator (10) according to claim 5, wherein said polarised capacitor (56) is configured to store a charge greater than the charge storable by the non-polarised capacitor (54).

7. Signal generator (10) according to any one of the preceding claims from 3 to 6, wherein said accumulator block (50) is charged by the power supply branch (30) and is discharged by the driving circuit assembly (20, 40) when the electronic processing unit (160) enables the driver (20).

8. Signal generator (10) according to any one of the preceding claims from 3 to 7, wherein said driver (20) has a consumption rate (Vc) of the charge stored in the accumulator block (50) greater than the storage rate (Vs) of the same charge in the accumulator block (50) so as to allow the driver (20) to automatically deactivate and interrupt the signal generation.

9. Signal generator (10) according to any one of the preceding claims from 2 to 8, wherein said travel branch (60) comprises:
- .at least one resistance (62); and
- .at least one bypass switch (64) connected to each other in parallel.

10. Signal generator (10) according to the preceding claim, wherein the at least one bypass switch (64) is controllable to switch between a closed conduction configuration and an open interdiction configuration as a function of the number of batteries present in the battery string (12) to increase or decrease the electrical resistance of the travel branch (60).

11. Signal generator (10) according to any one of claims 3-10, wherein the signal modulator (40) comprises at least one electronic switch (41) controllable to switch between an open configuration and a closed configuration so as to generate a periodic signal.

12. Electronic device (100) for measuring the battery resistance of a battery string (12), comprising:
- .a signal generator (10) according to any one of claims 1-11;
- .a primary measuring block (300) adapted to measure an alternating electrical signal magnitude (M1) representative of the alternating electrical signal generated by the signal generator (10);
- .at least one secondary measuring block (200) adapted to measure a battery magnitude (M2) representative of a battery electrical signal of at least one battery present in the battery string (12) crossed by the alternating electrical signal, the alternating electrical signal magnitude (M1) being comparable with the battery magnitude (M2);
- .at least one electronic processing unit (160) operatively connected to the alternating electrical signal generator (10) and configured to:
- .determine the parameters of the alternating electrical signal and supply said parameters to the driving circuit assembly;
- .receive from said primary measuring block and from said secondary measuring block the alternating electrical signal magnitude (M1) and the battery magnitude (M2);
the at least one electronic processing unit being provided with, or operatively connected to, a resistance meter adapted to determine the internal resistance value of at least one battery present in the battery string (12) by comparing the alternating electrical signal magnitude (M1) with the battery magnitude (M2).

13. Electronic device (100) according to the preceding claim, wherein the at least one secondary measuring block (200) is operatively connected to the ends of the at least one battery of the battery string (12) to measure the voltage of said at least one battery present in the battery string (12).

14. Electronic device (100) according to claim 12, comprising a multiplexer (130) connected to the battery string (12) and configured to select a battery of the battery string (12), the multiplexer being operatively connected to the at least one secondary measuring block (200).

15. Electronic device (100) according to any one of claims 12-14, wherein the primary measuring block (300) comprises:
- .a primary signal-conditioning path (150); and
- .a primary analogue-to-digital converter ADC (162);
and wherein the secondary measuring block (200) comprises:
- .a secondary signal-conditioning path (140); and
- .a secondary analogue-to-digital converter ADC (161);
or wherein the primary measuring block (300) comprises a primary signal-conditioning path (150)
and wherein the secondary measuring block (200) comprises a secondary signal-conditioning path (140), wherein the primary and secondary analogue-to-digital converters ADC (162, 161) are integrated in a microprocessor containing the electronic processing unit (160).

16. Electronic device (100) for measuring the battery resistance of a battery string (12), comprising:
- .a signal generator (10) according to any one of claims 1-11;
- .a primary measuring block (300) adapted to measure an alternating electrical signal magnitude (M1) representative of the alternating electrical signal generated by the signal generator (10);
- .at least one secondary measuring block (200) adapted to measure a battery magnitude (M2) representative of a battery electrical signal of at least one battery present in the battery string (12) crossed by the alternating electrical signal, the alternating electrical signal magnitude (M1) being comparable with the battery magnitude (M2);
- .at least two electronic processing units (170, 180), wherein:
- .a first electronic processing unit (170) is configured to receive the alternating electrical signal magnitude (M1) from the primary measuring block (300);
- .at least a second electronic processing unit (180) is configured to receive the battery electrical signal magnitude (M2) from the secondary measuring block (200);
and wherein:
- .one of said first electronic processing unit (170) and said at least one second electronic processing unit (180) is configured to send to the other one of said first electronic processing unit (170) and said at least one second electronic processing unit (180) the respective electrical signal magnitude, being provided with, or operatively connected to, a resistance meter adapted to determine the internal resistance value of at least one battery present in the battery string (12) by comparing the alternating electrical signal magnitude (M1) with the battery magnitude (M2);
or, wherein the electronic device comprises a resistance meter adapted to determine the internal resistance value of at least one battery present in the battery string (12) by comparing the alternating electrical signal magnitude (M1) with the battery magnitude (M2), and wherein said first electronic processing unit (170) and said at least one second electronic processing unit (180) are configured to send the respective electrical signal magnitude to said resistance meter.

17. Electronic device (100) according to any one of claims 12-16, wherein the alternating electrical signal is a current signal, wherein the electronic device comprises an alternating current transducer (120) operatively connected to the signal generator (10) and adapted to proportionally convert the alternating current signal into an alternating voltage signal, wherein the alternating electrical signal magnitude (M1) is the alternating voltage signal module and the battery magnitude (M2) is the battery voltage module.
